# EUROPEAN PATENT SPECIFICATION

(11) **EP 1 873 790 B1**
(45) Date of publication and mention of the grant of the patent: **14.09.2011**
(21) Application number: 06728673.2
(22) Date of filing: 07.03.2006
(51) Int. Cl.: H01B 1/22, H01L 21/28, H01L 21/288, H01L 31/04

(54) **PASTE COMPOSITION, ELECTRODE AND SOLAR CELL DEVICE COMPRISING SAME**
PASTENZUSAMMENSETZUNG, ELEKTRODE UND SOLARZELLENEINRICHTUNG DAMIT
COMPOSITION DE PATE, ELECTRODE ET DISPOSITIF DE CELLULE SOLAIRE LES COMPRENANT

(30) Priority: 29.03.2005 JP 2005093339
(43) Date of publication of application: 02.01.2008
(73) Proprietor: TOYO ALUMINIUM KABUSHIKI KAISHA, Osaka-shi, Osaka 541-0056 (JP)
(72) Inventor: KIKUCHI, Ken, machi 3-Chome, Chuo-ku, Osaka-shi, Osaka (JP); NAKAHARA, Jun, machi 3-Chome, Chuo-ku, Osaka-shi, Osaka (JP); WATSUJI, Takashi, machi 3-Chome, Chuo-ku, Osaka-shi, Osaka (JP); LAI, Gaochao, machi 3-Chome, Chuo-ku,Osaka-shi, Osaka, (JP); YOKOE, Kazuhiko, machi 3-Chome, Chuo-ku, Osaka-shi, Osaka (JP)
(74) Representative: Grünecker, Kinkeldey, Stockmair & Schwanhäusser Anwaltssozietät
(86) International application number: PCT/JP2006/304304
(87) International publication number: WO 2006/103882

(56) References cited:
- JP-A- 6 333 417
- JP-A- 04 018 703
- JP-A- 05 011 265
- JP-A- 05 183 314
- JP-A- 61 094 391
- JP-A- 2000 090 733
- JP-A- 2000 090 734
- JP-A- 2000 119 518
- JP-A- 2003 223 813
- JP-A- 2004 051 755
- JP-A- 2004 134 775

## Description

### TECHNICAL FIELD

The present invention generally relates to a paste composition, an electrode, and a solar cell element including the same. More specifically, the present invention relates to a paste composition for use in forming an electrode on a silicon semiconductor substrate constituting a crystalline silicon solar cell, an electrode, and a solar cell element including the same.

### BACKGROUND ART

A solar cell is known as an electronic element obtained by forming electrodes on a silicon semiconductor substrate.

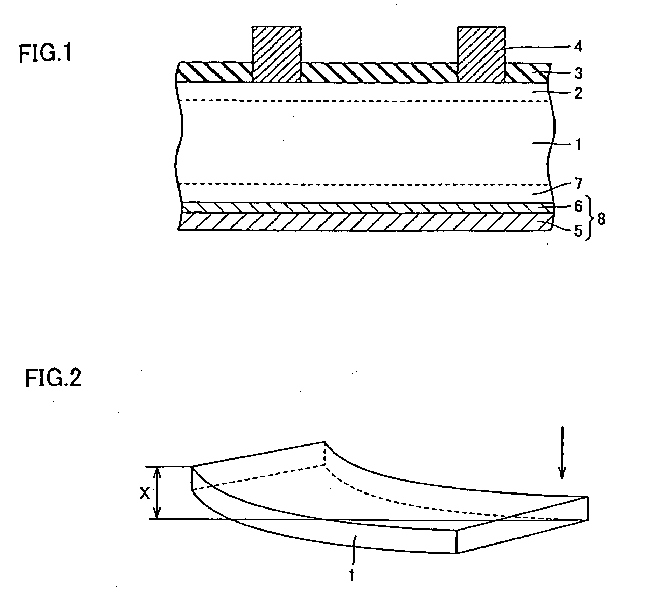

Fig. 1 is a schematic view which shows a general sectional structure of a solar cell element.

As shown in Fig. 1, the solar cell element is formed using a p-type silicon semiconductor substrate 1 having a thickness of 200 to 300 µm. On the photoreceptive surface of the silicon semiconductor substrate 1, an n-type impurity layer 2 having a thickness of 0.3 to 0.6 µm is provided. Further, an antireflection film 3 and a grid electrode 4 are provided on the n-type impurity layer 2.

On the other hand, on the back surface of the p-type silicon semiconductor substrate 1, a back electrode layer 5 is provided. The back electrode layer 5 is formed by coating the p-type silicon semiconductor substrate 1 with a paste composition composed of aluminum powder, glass frit, and an organic vehicle by, for example, screen printing, and drying the paste composition, and firing the paste composition at a temperature of 660°C (i.e., the melting point of aluminum) or higher. During the firing of the paste composition, aluminum is diffused into the p-type silicon semiconductor substrate 1, so that an Al-Si alloy layer 6 is formed between the back electrode layer 5 and the p-type silicon semiconductor substrate 1, and at the same time, a p⁺ layer 7 is also formed as an impurity layer resulting from the diffusion of aluminum atoms. The existence of the p⁺ layer 7 prevents the recombination of electrons, and therefore a BSF (Back Surface Field) effect improving the collection efficiency for generated carriers can be obtained. An electrode 8 is composed of the back electrode layer 5 and the Al-Si alloy layer 6.

It is to be noted that the back electrode layer 5 and the Al·Si alloy layer 6 may be removed with, for example, acid to form another electrode layer using, for example, a silver paste on the remaining p⁺ layer 7 providing a BSF effect. A solar cell having such a structure is also in practical use.

Meanwhile, an attempt to reduce the cost of such a solar cell by reducing the thickness of the silicon semiconductor substrate has been recently made. However, reduction in the thickness of the silicon semiconductor substrate causes bow deformation of the silicon semiconductor substrate after the firing of the paste due to the difference in coefficient of thermal expansion between silicon and aluminum, so that the back surface of the silicon semiconductor substrate having the back electrode layer thereon is concaved. This causes a problem that cracking or the like occurs during the manufacturing of the solar cell, thereby lowering the manufacturing yield of the solar cell.

In order to solve the problem, there is known a method in which the amount of the paste composition applied onto the silicon semiconductor substrate is reduced to reduce the thickness of the back electrode layer. However, in a case where the amount of the paste composition applied onto the silicon semiconductor substrate is reduced, the amount of aluminum diffused from the surface to the inside of the silicon semiconductor substrate becomes insufficient. This causes another problem that a desired BSF effect cannot be achieved, thereby deteriorating the characteristics of the solar cell.

Further, Japanese Patent Application Laid-open No. 2000-90734 (Patent Document 1) discloses a conductive paste composition capable of allowing a solar cell to have desired characteristics and reducing the bow of a silicon semiconductor substrate. This conductive paste contains an aluminum-containing organic compound in addition to aluminum powder, glass frit, and an organic vehicle.

According to the prior art described above, it is necessary to reduce the thickness of a back electrode layer to reduce the amount of bow of a silicon semiconductor substrate. In this case, there is a fear that a reduction in the thickness of a back electrode layer deteriorates a BSF effect.

Further, Japanese Patent Application Laid-open No. 2004-134775 (Patent Document 2) discloses a method for reducing the bow of a silicon semiconductor substrate by adding at least one of organic compound particles and carbon particles to a conventional paste composition to suppress the shrinkage of an aluminum electrode occurring during the firing of the paste composition. According to such a method, the organic compound particles or the carbon particles are present in a solid particle state in the paste composition, but these particles are burnt and then disappear during the firing of the paste composition, and as a result, a plurality of micro pores are formed in an obtained electrode, thereby suppressing the bow of a silicon semiconductor substrate.

However, formation of pores in an aluminum electrode reduces the mechanical strength of the aluminum electrode and the adhesion of the aluminum electrode to the silicon semiconductor substrate. Under present circumstances, there is no known method and paste composition for reducing the amount of bow of a silicon semiconductor substrate without reducing the mechanical strength of an obtained electrode and the adhesion of the electrode to the silicon semiconductor substrate to satisfactorily obtain a desired BSF effect.
Patent Document 1: Japanese Patent Application Laid-open No. 2000-90734
Patent Document 2: Japanese Patent Application Laid-open No. 2004-134775

### DISCLOSURE OF THE INVENTION

### Problems to be solved by the Invention

In order to solve the above problems, it is an object of the present invention to provide a paste composition capable of, even when the thickness of a silicon semiconductor substrate is reduced, satisfactorily achieving a desired BSF effect and suppressing the deformation (bow) of the silicon semiconductor substrate occurring after the firing of the paste composition without reducing the mechanical strength of an obtained electrode and the adhesion of the electrode to the silicon semiconductor substrate, an electrode formed using the composition, and a solar cell element including an electrode formed using the composition.

### Means for solving the problems

In order to solve the problems of the prior art, the present inventors have made an extensive study, and as a result have found that the use of a paste composition having a specific composition makes it possible to achieve the above object.

Based on the above findings, the present invention is directed to a paste composition to be used for forming an electrode on a silicon semiconductor substrate, including: aluminum powder; an organic vehicle; and whisker insoluble or hardly-soluble in the organic vehicle, wherein the whisker is previously mixed with the aluminum powder and the organic vehicle.

It is preferred that the paste composition according to the present invention further includes glass frit.

Further, it is also preferred that the paste composition according to the present invention contains the whisker in an amount of 0.2% by mass or more but 15.0% by mass or less.

Further, it is also preferred that the paste composition according to the present invention contains the aluminum powder in an amount of 60% by mass or more but 80% by mass or less, the organic vehicle in an amount of 20% by mass or more but 40% by mass or less, and the whisker in an amount of 0.2% by mass or more but 15.0% by mass or less.

In a case where the paste composition according to the present invention includes glass frit, the paste composition preferably contains the aluminum powder in an amount of 60% by mass or more but 80% by mass or less, the organic vehicle in an amount of 20% by mass or more but 40% by mass or less, the whisker in an amount of 0.2% by mass or more but 15.0% by mass or less, and the glass frit in an amount of 7.0% by mass or less.

In the paste composition according to the present invention, the whisker is preferably at least one selected from the group consisting of metals, inorganic materials, and organic materials.

Further, in the paste composition according to the present invention, the whisker preferably has a diameter of 15 µm or less and an aspect ratio of 2 or more.

The present invention is also directed to an electrode formed by applying a paste composition having any one of the above-described characteristics onto a silicon semiconductor substrate and then firing the paste composition.

The present invention is also directed to a solar cell element including an electrode formed by applying a paste composition having any one of the above-described characteristics onto a silicon semiconductor substrate and then firing the paste composition.

### Effect of the Invention

As described above, even when the thickness of a silicon semiconductor substrate is reduced, the use of the paste composition according to the present invention containing whisker makes it possible to reduce the deformation of the silicon semiconductor substrate occurring after the firing of the paste composition applied onto the silicon semiconductor substrate without the necessity to reduce the amount of the paste composition applied onto the silicon semiconductor substrate, so that an obtained aluminum electrode has mechanical strength and good adhesion to the silicon semiconductor substrate and therefore a desired BSF effect improving the collection efficiency for generated carriers is achieved.

### BRIEF DESCRIPTION OF THE DRAWINGS

Fig. 1 is a schematic view which shows a general sectional structure of one embodiment of a solar cell element to which the present invention is applied.
Fig. 2 is a schematic view which shows a method used in examples and comparative examples for measuring the amount of bow of a p-type silicon semiconductor substrate having thereon an aluminum electrode layer formed by firing.

### Description of Reference Numerals

- 1: p-type silicon semiconductor substrate
- 2: n-type impurity layer
- 3: antireflection film
- 4: grid electrode
- 5: back electrode layer
- 6: Al-Si alloy layer
- 7: p⁺ layer
- 8: electrode

### DETAILED DESCRIPTION OF THE INVENTION

A paste composition according to the present invention is characterized by containing whisker in addition to aluminum powder and an organic vehicle. By using such a paste composition containing whisker as a paste applied onto a silicon semiconductor substrate, it is possible to suppress the deformation of a silicon semiconductor substrate occurring after the firing of the paste composition.

Heretofore, there is no substantially effective method for suppressing the deformation of a silicon semiconductor substrate occurring after the firing of a paste, other than addition of predetermined powder particles to a paste or reduction in the thickness of a coating of a paste. Addition of powder particles to a paste has the effect of suppressing the deformation of a silicon semiconductor substrate to some degree, but this causes a problem of reduction in the mechanical strength of an obtained electrode and in the adhesion of the electrode to the silicon semiconductor substrate. On the other hand, reduction in the thickness of a coating of a paste can reduce the amount of deformation of a silicon semiconductor substrate, but the amount of aluminum diffused from the surface to the inside of the silicon semiconductor substrate becomes insufficient and therefore a desired BSF effect cannot be obtained, thereby deteriorating the characteristics of a solar cell.

However, the use of the paste composition according to the present invention makes it possible to suppress the deformation of a silicon semiconductor substrate occurring after the firing of the paste composition without the necessity to reduce the thickness of a coating of the paste composition, whereby a desired BSF effect can be obtained. The reason why the use of the paste composition obtained by previously mixing whisker with aluminum powder and an organic vehicle makes it possible to suppress the deformation of a silicon semiconductor substrate occurring after the firing of the paste composition is not clear, but it can be considered that the amount of shrinkage of a sintered aluminum layer, formed by firing of the paste composition, occurring during cooling after firing is reduced due to the existence of the whisker. In addition, it is possible to prevent a reduction in the mechanical strength of the aluminum electrode and a reduction in the adhesion of the aluminum electrode to the silicon semiconductor substrate because of the dispersion of the whisker in the aluminum powder.

As the whisker contained in the paste composition according to the present invention, at least one selected from the group consisting of metals, inorganic materials, and organic materials can be used, as long as it is not dissolved in the organic vehicle and is not thermally decomposed during firing of the paste composition.

The amount of the whisker contained in the paste composition according to the present invention is preferably 0.2% by mass or more but 15.0% by mass or less. If the amount of the whisker contained in the paste composition according to the present invention is less than 0.2% by mass, the effect obtained by adding the whisker is not high enough to suppress the deformation of a silicon semiconductor substrate occurring after the firing of the paste composition. On the other hand, if the amount of the whisker contained in the paste composition according to the present invention exceeds 15.0% by mass, there is a fear that the sinterability of the paste composition is adversely affected, which causes a problem that the electric resistance of a back electrode layer is increased. If the electric resistance of a back electrode layer is increased, an ohmic resistance between electrodes is increased and therefore energy generated by irradiation with solar light cannot be effectively extracted from a solar cell, thereby lowering the energy conversion efficiency of the solar cell.

The diameter of the whisker contained in the paste composition according to the present invention is preferably 15 µm or less. If the diameter of the whisker exceeds 15 µm, the number of whiskers dispersed in a sintered aluminum layer formed by firing of the paste composition is reduced, and therefore the effect obtained by adding the whisker is not high enough to suppress the deformation of a silicon semiconductor substrate occurring after the firing of the paste composition.

The amount of the aluminum powder contained in the paste composition according to the present invention is preferably 60% by mass or more but 80% by mass or less. If the amount of the aluminum powder contained in the paste composition according to the present invention is less than 60% by mass, there is a fear that the surface resistance of a back electrode layer formed by firing of the paste composition is increased, thereby lowering the energy conversion efficiency of a solar cell. On the other hand, if the amount of the aluminum powder contained in the paste composition according to the present invention exceeds 80% by mass, the ability of the paste composition to be applied onto a silicon semiconductor substrate by screen printing or the like is lowered.

The organic vehicle contained in the paste composition according to the present invention can be prepared by dissolving ethyl cellulose, acrylic resin, alkyd resin, or the like in a glycol ether-based solvent, a terpineol-based solvent, or the like. The amount of the organic vehicle contained in the paste composition according to the present invention is preferably 20% by mass or more but 40% by mass or less. If the amount of the organic vehicle contained in the paste composition according to the present invention is less than 20% by mass or exceeds 40% by mass, printability of the paste composition is lowered.

The paste composition according to the present invention may further contain glass frit. The amount of the glass frit contained in the paste composition according to the present invention is preferably 7.0% by mass or less. The glass frit is not directly involved in the deformation of the silicon semiconductor substrate, a BSF effect, and energy conversion efficiency, but addition of the glass frit improves the adhesion between a back electrode formed by firing of the paste composition and a silicon semiconductor substrate. If the amount of the glass frit contained in the paste composition according to the present invention exceeds 7.0% by mass, there is a fear that segregation of glass occurs.

Examples of the glass frit contained in the paste composition according to the present invention include SiO₂-Bi₂O₃-PbO-based glass frit, B₂O₃-SiO₂-Bi₂O₃-based glass frit, B₂0₃-SiO₂-ZnO-based glass frit, and B₂O₃-SiO₂-PbO-based glass frit.

### EXAMPLES

Hereinbelow, one embodiment of the present invention will be described.

First, various paste compositions each containing whisker or powder having characteristics shown in Table 1 in a ratio shown in Table 2 as well as 60 to 80% by mass of aluminum powder, 0 to 7.0% by mass of glass frit, and 20 to 40% by mass of an organic vehicle were prepared.

More specifically, ethyl cellulose was dissolved in a glycol ether-based organic solvent to prepare an organic vehicle, and aluminum powder and B₂O₃-SiO₂-PbO-based glass frit were added to the organic vehicle, and then any one of whiskers shown in Table 1 was added thereto in an amount shown in Table 2. The thus obtained mixture was mixed using a well-known mixer to prepare a paste composition (Examples 1 to 5). Paste compositions of Comparative Examples 2 and 3 were also prepared in the same manner as in Examples 1 to 5 except that the whisker was replaced with any one of powders shown in Table 1 and the powder was added in an amount shown in Table 2. Further, a paste composition of Comparative Example 1 containing neither whisker nor powder shown in Table 1 was also prepared. It is to be noted that in Table 2, the symbols "W" and "P" in parenthesis in the column "Type of Additive" represent whisker and powder, respectively.

It is to be noted that the aluminum powder used for preparing these paste compositions was composed of spherical or nearly-spherical particles having an average particle diameter of 2 to 20 µm from the viewpoint of ensuring of reactivity with a silicon semiconductor substrate, the ability of the paste composition to be applied onto a silicon semiconductor substrate, and the uniformity of a coating of the paste composition.

Each of the paste compositions was applied onto a p-type silicon semiconductor substrate having a thickness of 200 µm and a size of 155 mm x 155 mm by printing using a 250 mesh-screen printing plate, and then dried. It is to be noted that the amount of the paste composition applied onto the p-type silicon semiconductor substrate was so determined that an electrode obtained by firing the paste composition had a thickness of 25 to 30 µm.

The p-type silicon semiconductor substrate having the printed paste composition was dried, and was then heated in an infrared firing furnace in an air atmosphere at a heating rate of 400°C/min and fired by keeping it at 720°C for 30 seconds. After firing, the p-type silicon semiconductor substrate was cooled to obtain a p-type silicon semiconductor substrate 1 having a back electrode layer 5 as shown in Fig. 1.

The surface resistance of the back electrode layer, exerting an influence on the ohmic resistance between electrodes, was measured using a four-point probe surface resistance measuring device.

Then, the p-type silicon semiconductor substrate having the back electrode layer was immersed in an aqueous hydrochloric acid solution to dissolve and remove the back electrode layer 5 and an Al-Si alloy layer 6, and then the surface resistance of the p-type silicon semiconductor substrate having a p⁺ layer 7 formed thereon was measured using the surface resistance measuring device described above.

It is supposed that there is a correlation between the surface resistance of the P⁺ layer 7 and a BSF effect and the smaller the surface resistance of the P⁺ layer 7 is, the higher the BSF effect is. The target surface resistances of the back electrode layer and the p⁺ layer are 24.0 mΩ/□ or less and 22.0 Ω/□ or less, respectively.

The deformation of the silicon semiconductor substrate occurring after the firing of the paste composition was evaluated by measuring the amount of deformation after cooling of the silicon semiconductor substrate in the following manner. As shown in Fig. 2, the silicon semiconductor substrate was placed on a plane with the back electrode layer side up, and one of the four corners of the substrate was pressed against the plane to measure the amount of elevation "x" (including the thickness of the substrate) of another corner diagonally opposite to the corner pressed against the plane. It is to be noted that the target value of "x" is 2.0 mm or less.

The mechanical strength and adhesion of the aluminum electrode formed on the silicon semiconductor substrate were evaluated based upon whether or not the aluminum electrode was separated from the substrate when a cellophane tape adhered to the aluminum electrode was peeled off from the aluminum electrode.

The measurement results of the surface resistance of the back electrode layer, the surface resistance of the p⁺ layer, the amount of deformation of silicon (Si) substrate occurring after firing, and the adhesion properties of the back (aluminum) electrode are shown in Table 2.

**Table 1**

| Additive | Type | Diameter/Particle diameter (µm) | Aspect ratio |
|---|---|---|---|
| 9Al₂O₃- 2B₂O₃ | Whisker | 0.4∼1.2 | 10∼40 |
| SiC | Whisker | 0.2∼0.6 | 20∼50 |
| Si₃N₄ | Whisker | 0.8∼1.5 | 5∼25 |
| SiC | Powder | 0.2 | <2 |
| C | Powder | 0.1 | <2 |

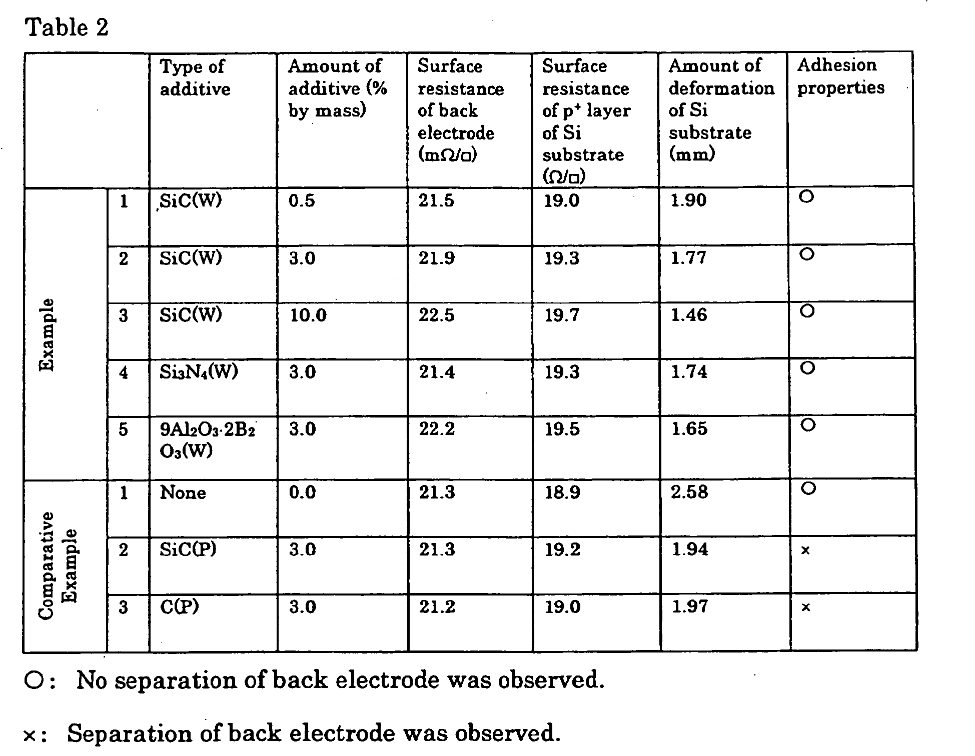

As can be seen from Table 2, the amount of deformation of the silicon substrate occurring after the firing of a conventional paste composition (Comparative Example 1) was well over 2.0 mm, whereas the amount of deformation of the silicon substrate occurring after the firing of each of the paste compositions according to the present invention (Examples 1 to 5) containing not only aluminum powder and an organic vehicle but also 0.2% by mass or more of whisker was reduced to less than 2.0 mm.

In the case of the paste compositions (Comparative Examples 2 and 3) containing powder particles, the addition of powder particles had the effect of suppressing the deformation of the silicon substrate to some extent, but the mechanical strength of the aluminum electrode and the adhesion of the aluminum electrode to the silicon substrate were reduced. On the other hand, in the case of the paste compositions according to the present invention (Examples 1 to 5) containing whisker, the mechanical strength of the aluminum electrode and the adhesion of the aluminum electrode to the silicon substrate were not reduced.

### INDUSTRIAL APPLICABILITY

Even when the thickness of a silicon semiconductor substrate is reduced, the use of the paste composition according to the present invention containing whisker makes it possible to reduce the deformation of the silicon semiconductor substrate occurring after the firing of the paste composition applied onto the silicon semiconductor substrate without the necessity to reduce the amount of the paste composition applied onto the silicon semiconductor substrate. Further, an aluminum electrode formed using the paste composition according to the present invention has mechanical strength and good adhesion to the silicon semiconductor substrate, and therefore a solar cell element having an electrode formed using the paste composition according to the present invention has a desired BSF effect improving the collection efficiency for generated carriers.

## Claims

1. A paste composition to be used for forming an electrode (8) on a silicon semiconductor substrate (1), comprising:
aluminum powder;
an organic vehicle; and
whisker insoluble or hardly-soluble in the organic vehicle, wherein the whisker is previously mixed with the aluminum powder and the organic vehicle.

2. The paste composition according to claim 1, further comprising glass frit.

3. The paste composition according to claim 1, which contains the whisker in an amount of 0.2% by mass or more but 15.0% by mass or less.

4. The paste composition according to claim 1, which contains the aluminum powder in an amount of 60% by mass or more but 80% by mass or less, the organic vehicle in an amount of 20% by mass or more but 40% by mass or less, and the whisker in an amount of 0.2% by mass or more but 15.0% by mass or less.

5. The paste composition according to claim 2, which contains the aluminum powder in an amount of 60% by mass or more but 80% by mass or less, the organic vehicle in an amount of 20% by mass or more but 40% by mass or less, the whisker in an amount of 0.2% by mass or more but 15.0% by mass or less, and the glass frit in an amount of 7.0% by mass or less.

6. The paste composition according to claim 1, wherein the whisker is at least one selected from the group consisting of metals, inorganic materials, and organic materials.

7. The paste composition according to claim 1, wherein the whisker has a diameter of 15 µm or less and an aspect ratio of 2 or more.

8. An electrode (8) constituting a solar cell, which is formed by applying the paste composition according to claim 1 onto a silicon semiconductor substrate (1) and then firing the paste composition.

9. A solar cell element comprising an electrode (8) formed by applying the paste composition according to claim 1 onto a silicon semiconductor substrate (1) and then firing the paste composition.

## Patentansprüche

1. Pastenzusammensetzung, die zum Ausbilden einer Elektrode (8) auf einem Silizium-Halbleitersubstrat (1) verwendet wird, wobei sie umfasst:
ein Aluminiumpulver;
eine organische Trägersubstanz; und
Haarkristall (whisker), der in der organischen Trägersubstanz nicht oder kaum lösbar ist, wobei der Haarkristall zuvor mit dem Aluminiumpulver und der organischen Trägersubstanz vermischt wird.

2. Pastenzusammensetzung nach Anspruch 1, die des Weiteren Glasfritte enthält.

3. Pastenzusammensetzung nach Anspruch 1, die den Haarkristall in einer Menge von 0,2 Gew.-% oder mehr, jedoch 15,0 Gew.-% oder weniger, enthält.

4. Pastenzusammensetzung nach Anspruch 1, die das Aluminiumpulver in einer Menge von 60 Gew.-% oder mehr, jedoch 80 Gew.-% oder weniger, die organische Trägersubstanz in einer Menge von 20 Gew.-% oder mehr, jedoch 40 Gew.-% oder weniger, und den Haarkristall in einer Menge von 0,2 Gew.-% oder mehr, jedoch 15,0 Gew.-% oder weniger, enthält.

5. Pastenzusammensetzung nach Anspruch 2, die das Aluminiumpulver in einer Menge von 60 Gew.-% oder mehr, jedoch 80 Gew.-% oder weniger, die organische Trägersubstanz in einer Menge von 20 Gew.-% oder mehr, jedoch 40 Gew.-% oder weniger, den Haarkristall in einer Menge von 0,2 Gew.-% oder mehr, jedoch 15 Gew.-% oder weniger, und die Glasfritte in einer Menge von 7,0 Gew.-% oder weniger enthält.

6. Pastenzusammensetzung nach Anspruch 1, wobei der Haarkristall wenigstens aus der Gruppe ausgewählt wird, die aus Metallen, anorganischen Materialien und organischen Materialien besteht.

7. Pastenzusammensetzung nach Anspruch 1, wobei der Haarkristall einen Durchmesser von 15 µm oder weniger und ein Seitenverhältnis von 2 oder mehr hat.

8. Elektrode (8), die eine Solarzelle bildet und ausgebildet wird, indem die Pastenzusammensetzung nach Anspruch 1 auf ein Silizium-Halbleitersubstrat (1) aufgebracht wird und die Pastenzusammensetzung dann gebrannt wird.

9. Solarzellenelement, das eine Elektrode (8) umfasst, die ausgebildet wird, indem die Pastenzusammensetzung nach Anspruch 1 auf ein Silizium-Halbleitersubstrat (1) aufgebracht wird und die Pastenzusammensetzung dann gebrannt wird.

## Revendications

1. Composition de pâte à utiliser pour former une électrode (8) sur un substrat semi-conducteur en silicium (1), comprenant :
de la poudre d'aluminium ;
un véhicule organique ; et
de la trichite insoluble ou difficilement soluble dans le véhicule organique, dans laquelle la trichite est préalablement mélangée à la poudre d'aluminium et au véhicule organique.

2. Composition de pâte selon la revendication 1, comprenant en outre de la fritte de verre.

3. Composition de pâte selon la revendication 1, qui contient la trichite en une quantité supérieure ou égale à 0,2 % en masse mais inférieure ou égale à 15,0 % en masse.

4. Composition de pâte selon la revendication 1, qui contient la poudre d'aluminium en une quantité supérieure ou égale à 60 % mais inférieure ou égale à 80 % en masse, le véhicule organique en une quantité supérieure ou égale à 20 % en masse mais inférieure ou égale à 40 % en masse, et la trichite en une quantité supérieure ou égale à 0,2 % en masse mais inférieure ou égale à 15,0 % en masse.

5. Composition de pâte selon la revendication 2, qui contient la poudre d'aluminium en une quantité supérieure ou égale à 60 % en masse mais inférieure ou égale à 80 % en masse, le véhicule organique en une quantité supérieure ou égale à 20 % en masse mais inférieure ou égale à 40 % en masse, la trichite en une quantité supérieure ou égale à 0,2 % en masse mais inférieure ou égale à 15,0 % en masse, et la fritte de verre en une quantité inférieure ou égale à 7 % en masse.

6. Composition de pâte selon la revendication 1, dans laquelle la trichite est au moins un élément choisi parmi le groupe constitué des métaux, des matières inorganiques et des matières organiques.

7. Composition de pâte selon la revendication 1, dans laquelle la trichite présente un diamètre de 15 µm ou moins et un rapport d'aspect de 2 ou plus.

8. Electrode (8) constituant une cellule solaire, laquelle électrode est formée en appliquant la composition de pâte selon la revendication 1 sur un substrat semi-conducteur en silicium (1) puis en chauffant la composition de pâte.

9. Elément de cellule solaire comprenant une électrode (8) formée en appliquant la composition de pâte selon la revendication 1 sur un substrat semi-conducteur en silicium (1) puis en chauffant la composition de pâte.
